# EUROPÄISCHE PATENTSCHRIFT

(11) **EP 2 962 799 B1**
(45) Veröffentlichungstag und Bekanntmachung des Hinweises auf die Patenterteilung: **07.09.2016**
(21) Anmeldenummer: 14175716.1
(22) Anmeldetag: 04.07.2014
(51) Int. Cl.: B23K 20/10, B23K 37/06, H01R 43/02, H01L 23/00, H01L 23/48, H01L 23/498, H01L 21/48, B23K 26/12

(54) **Halbleitermodul mit Ultraschall geschweißten Anschlüssen**
Semiconductor module with ultrasound welded connections
Module semi-conducteur doté de raccords soudés aux ultrasons

(43) Veröffentlichungstag der Anmeldung: 06.01.2016
(73) Patentinhaber: ABB Technology AG, 8050 Zürich (CH)
(72) Erfinder: Hartmann, Samuel, 5603 Staufen (CH); Guillon, David, 8857 Vorderthal (CH); Hajas, David, 5102 Rupperswil (CH); Thut, Markus, 5703 Seon (CH)
(74) Vertreter: ABB Patent Attorneys

(56) Entgegenhaltungen:
- DE-A1-102006 026 659
- DE-A1-102010 005 043
- US-A- 5 115 961

## Beschreibung

### GEBIET DER ERFINDUNG

Die Erfindung betrifft ein Halbleitermodul und ein Verfahren zum Herstellen eines Halbleitermoduls.

### HINTERGRUND DER ERFINDUNG

Halbleitermodule können neben einem Gehäuse ein metallisiertes Substrat (beispielsweise aus Keramik) umfassen, an dem Halbleiterchips befestigt sind, sowie elektrische Anschlüsse, mit denen das Halbleitermodul bzw. dessen Chips elektrisch mit weiteren Komponenten verbunden werden können. Diese Anschlüsse, die in der Regel aus Kupfer gefertigt sind, können beispielsweise mittels Ultraschallschweißen mit der Metallschicht des Substrats verbunden werden.

Während des Ultraschallschweißens von Kupferanschlüssen an das Substrat können Partikel entstehen, die zu Schwierigkeiten führen können, wenn sie innerhalb des Moduls an kritischen Stellen, wie etwa Kontakten der Halbleiterchips oder auf der isolierenden Keramik, verbleiben.

Da diese Partikel dazu tendieren, an polymerischen Materialien wie etwa Polyimiden haften zu bleiben, kann es schwierig sein, die Partikel nach dem Schweißvorgang aus dem Modul zu entfernen.

Es ist möglich, die Partikel im Bereich um den Fuß des Anschlusses mit einem geeigneten Gehäuse einzuschließen, aber die metallisierte Anschlussschweißstelle müsste dazu sehr groß ausgelegt werden, so dass eine einschließende Struktur darauf platziert werden könnte. Würde die einschließende Struktur auf die isolierende Keramik gesetzt, könnte sie deren isolierende Wirkung vermindern. Weiter kann es sein, dass ein sich bewegendes Kunststoffteil das umgebende Silikon-Gel vom Metall und von der Keramik wegreißt, was die Isolation beeinträchtigen könnte.

Die WO 2014 000 975 A1 beschreibt beispielsweise ein Verfahren zum Ultraschallschweißen von Anschlusselementen an ein Substrat für elektronische Bauteile, bei dem die Schweißstelle während des Schweißvorgangs von einer Struktur umschlossen ist, die verhindern soll, dass Partikel, die während des Schweißvorgangs entstehen können, das Substrat verunreinigen.

Auch in der JP 2010 040 615 A2 soll verhindert werden, dass Partikel, die beim Ultraschallschweißen entstehen, ein Halbleitergerät verunreinigen. Dazu wird ein Kunststoff um die Schweißstelle aufgetragen.

Weiter wurde vorgeschlagen, das Ultraschallschweißen innerhalb eines Schaums durchzuführen, wobei die entstehenden Partikel dann nach dem Schweißen zusammen mit dem Schaum abgewaschen werden können. Dies führt in der Regel zu einem kostenintensiven Produktionsprozess.

Die US 4 970 618 beschreibt eine Computer-Diskette mit einem Gehäuse, das Ultraschall geschweißt ist und Abschnitte aufweist, die einen Luftstrom kontrollieren, wenn sich die magnetische Scheibe dreht, um zu verhindern, dass Partikel, die beim Ultraschallschweißen erzeugt wurden, auf die Diskette gelangen können.

Die US 5,115,961 betrifft ein Verfahren und eine Vorrichtung zum Aufbringen einer Auskleidung für die Hülle einer Diskette.

Die DE 10 2010 005 043 A1 offenbart eine Schweißeinrichtung mit zumindest einer Abschirmeinrichtung, die eine Schweiß-stelle zumindest bereichsweise umgibt und abschirmt. Zudem ist eine Absaugvorrichtung vorgesehen, die mit der Abschirmeinrichtung kommunizierend verbunden ist und die zumindest während des Schweißvorgangs den Bereich der Schweißstelleständig absaugt, so dass eine Schweißbearbeitung in einem Volumenstrom der Absaugvorrichtung erfolgt.

In der DE 10 2006 026 659 A1 ist eine Schweißvorrichtung mit zumindest einem Schweißbrenner oder ähnlichem angegeben, mit dem Werkstücke unter verschiedenen Bedingungen und mit verschiedenen Formen geschweißt werden können. Am Schweißbrenner ist ein Barriereelement angeordnet ist, wobei das Barriereelement den Kontaktbereich (Schweißstelle) zumindest bereichsweise umgibt.

### ZUSAMMENFASSUNG DER ERFINDUNG

Es ist Aufgabe der Erfindung, ein ausfallsicheres, zuverlässiges und kostengünstiges Halbleitermodul bereitzustellen.

Diese Aufgabe wird durch den Gegenstand der unabhängigen Ansprüche gelöst. Weitere Ausführungsformen der Erfindung ergeben sich aus den abhängigen Ansprüchen und aus der folgenden Beschreibung.

Ein Aspekt der Erfindung betrifft ein Halbleitermodul. Ein Halbleitermodul kann beispielsweise eine Brückenschaltung aus mehreren Transformatoren, Dioden und/oder Thyristoren tragen. Diese werden auf einem oder mehreren Halbleiterchips bereitgestellt. Insbesondere kann das Halbleitermodul Hochleistungshalbleiter umfassen, die dazu ausgeführt sind, mehr als 10 A und/oder 1000 V zu verarbeiten.

Gemäß einer Ausführungsform der Erfindung umfasst das Halbleitermodul eine Basisplatte (beispielsweise aus Kupfer oder AISi), ein Substrat auf der Basisplatte, das eine Metallisierung (beispielsweise aus Kupfer) auf wenigstens einer Seite aufweist und das wenigstens einen Halbleiterchip trägt, ein Gehäuse (beispielsweise aus Kunststoff), das an der Basisplatte befestigt ist und das Substrat wenigstens teilweise umschließt, und wenigstens einen Anschluss (beispielsweise aus Kupfer), der mit einem Ende aus dem Gehäuse herausragt und der an einem anderen Ende einen Anschlussfuß aufweist, der mittels Ultraschallschweißen auf einer Anschlussstelle der Metallisierung befestigt ist.

Das Gehäuse weist eine Schutzwandung auf, die den Anschluss um den Anschlussfuß herum umgibt und einen Innenraum des Gehäuses in einen ungeschützten Bereich und einen geschützten Bereich unterteilt, wobei die Schutzwandung derart ausgebildet ist, dass zwischen dem Substrat und der Schutzwandung ein Spalt gebildet ist, der dazu ausgeführt ist, einen Fluidstrom (beispielsweise einen Luftstrom) derart zu führen, dass beim Ultraschallschweißen des Anschlussfußes auf die Anschlussstelle entstehende Partikel davon abgehalten werden, von dem ungeschützten Bereich in den geschützten Bereich zu dringen.

Das Gehäuse des Halbleitermoduls ist damit so strukturiert, dass während des Ultraschallschweißens ein kontinuierlicher Luftstrom zwischen geschützten und ungeschützten Bereichen des Moduls erzeugt werden kann. Auf diese Weise können die Partikel nicht die geschützten Bereiche erreichen. Weiter können die Partikel aus dem Halbleitermodul mit dem Luftstrom hinausgeblasen werden. Da keine Partikel im Gehäuse bleiben, ist die Ausfallrate des Halbleitermoduls geringer.

Zusammenfassend separiert eine Schutzwandung des Gehäuses geschützte und ungeschützte Bereiche im Innenraum des Gehäuses, wobei die Schutzwandung nicht auf dem Substrat aufsetzt, sondern einen Spalt bzw. Schlitz freilässt. Auf diese Weise schützt die Schutzwandung zusammen mit dem Luftstrom den geschützten Bereich vor Partikeln, die beim Schweißen entstehen. Wegen des Spalts muss die Schutzwandung nicht auf dem Substrat befestigt werden, was zu keinerlei Problemen hinsichtlich potentieller Schwächungen der Metallisierung oder der Isolation führt. Die Schutzwandung kann nach dem Schweißen im Modul verbleiben.

Es ist zu verstehen, dass das Modul genau einen oder mehrere geschützte Bereiche aufweisen kann. Genauso kann das Modul genau einen oder mehrere ungeschützte Bereiche aufweisen.

Gemäß einer Ausführungsform der Erfindung weist das Gehäuse eine Einlassöffnung auf, die in den geschützten Bereich mündet, durch die ein Fluid in den geschützten Bereich einblasbar ist. Der geschützte Bereich weist eine Öffnung zum Einlassen des Fluids auf. Über dieser Öffnung kann beispielsweise während des Ultraschallschweißens der Auslass eines Gebläses angeordnet werden, der Luft oder ein anderes Gas (Stickstoff, Inertgas) in die Einlassöffnung bläst.

Gemäß einer Ausführungsform der Erfindung ist die Einlassöffnung von einem Gehäuseeinsatz verschlossen. Das Gehäuse kann einstückig aus Kunststoff hergestellt und vor dem Schweißen mit der Basisplatte verbunden worden sein. Nach dem Schweißen kann die Einlassöffnung mit einem Einsatz (Stopfen) verschlossen werden.

Gemäß einer Ausführungsform der Erfindung weist das Gehäuse eine Auslassöffnung auf, die über einen durch die Schutzwandung gebildeten Kanal in den ungeschützten Bereich und/oder zum Anschlussfuß führt. Beispielsweise ist es möglich, einen Fluidstrom durch Saugen an der Auslassöffnung zu erzeugen. Der ungeschützte Bereich weist somit eine Öffnung zum Ausblasen der Partikel auf. Diese Öffnung kann auch die Öffnung sein, durch die der Anschluss auf die Anschlussstelle besetzt wird und/oder durch eine Sonotrode auf den Anschlussfuß gesetzt wird.

Gemäß einer Ausführungsform der Erfindung ist die Auslassöffnung von einem Gehäuseeinsatz verschlossen. Beide Öffnungen (Auslassöffnung und Einlassöffnung) können durch zusätzliche Gehäuseeinsätze verschlossen werden.

Gemäß einer Ausführungsform der Erfindung ragt der Anschluss aus der Auslassöffnung heraus. Beispielsweise kann der Anschluss aus einem Metallstreifen gebildet sein, der außerhalb des Gehäuses kontaktiert werden kann.

Gemäß einer Ausführungsform der Erfindung deckt das Gehäuse den geschützten Bereich bis auf eine Einlassöffnung vollständig ab bzw. umschließt diesen Bereich bis auf die Einlassöffnung vollständig. Der geschützte Bereich wird im Wesentlichen vom Gehäuse abgedeckt, um zu verhindern, dass ausgeblasene Partikel wieder in das Halbleitermodul hineinfallen.

Gemäß einer Ausführungsform der Erfindung weist das Gehäuse eine Deckplatte auf, die über eine Seitenwandung des Gehäuses an der Basisplatte befestigt ist. Das Gehäuse kann das Substrat somit kastenartig überdecken. Die Schutzwandung ist mit der Deckplatte verbunden und kann in den Innenraum des Gehäuses hineinragen. Somit kann die Schutzwandung einen von der Deckplatte ausgehenden Kanal zurAnschlussstelle bilden.

Gemäß einer Ausführungsform der Erfindung sind die Auslassöffnung(en) und/oder die Einlassöffnung(en) in der Deckplatte vorgesehen. Diese Öffnungen sind während der Herstellung des Moduls alle von einer Seite (von oben) zugänglich.

Gemäß einer Ausführungsform der Erfindung sind alle Halbleiterchips und/oder alle freiliegenden Bereiche des Substrats ohne Metallisierung im geschützten Bereich angeordnet. Mit anderen Worten können sich nur die Anschlussstellen im ungeschützten Bereich befinden.

Gemäß einer Ausführungsform der Erfindung weist der Spalt 0,2 bis 4 mal eine Dicke des Anschlussfußes auf, beispielsweise weist der Spalt 0,4 bis 2 mal eine Dicke des Anschlussfußes auf. Der Anschlussfuß kann beispielsweise eine Dicke von 1 bis 1,5 mm aufweisen. Auf diese Weise kann erreicht werden, dass das Fluid im Spalt eine Geschwindigkeit erreicht, die sicherstellt, dass Partikel, die beim Ultraschallschweißen eine Geschwindigkeit von 10 m/s erreichen können, den Spalt nicht durchdringen können.

Gemäß einer Ausführungsform der Erfindung sind mehr als ein Anschluss von der Schutzwandung umgeben. Die Schutzwandung kann beispielsweise einen Kanal mit länglichem Querschnitt bilden.

Gemäß einer Ausführungsform der Erfindung ist der Anschluss an dem Ende, das aus dem Gehäuse herausragt, abgewinkelt und umgreift das Gehäuse. Beispielsweise kann der Anschluss aus einem Metallstreifen hergestellt sein, der bereits vor dem Schweißen ein- oder mehrmals abgewinkelt wurde, um den Anschlussfuß und/oder das herausragende Ende zu bilden. Damit kann der Anschluss bereits in seiner Endform mit dem Modul verschweißt werden.

Ein weiterer Aspekt der Erfindung betrifft ein Verfahren zum Herstellen eines Halbleitermoduls, so wie es etwa obenstehend und untenstehend beschrieben ist. Es ist zu verstehen, dass Merkmale des Verfahrens, so wie obenstehend und untenstehend beschrieben, auch Merkmale des Halbleitermoduls sein können und umgekehrt.

Gemäß einer Ausführungsform der Erfindung umfasst das Verfahren: Bereitstellen eines Halbleitermoduls mit einer Basisplatte, einem Substrat auf der Basisplatte, und einem Gehäuse, das an der Basisplatte befestigt ist; Platzieren eines Anschlussfußes eines Anschlusses auf einer Anschlussstelle des Substrats, die von einer Schutzwandung des Gehäuses umgeben ist, die dann den Anschluss um den Anschlussfuß herum umgibt, wobei die Schutzwandung einen Innenraum des Gehäuses in einen ungeschützten Bereich und einen geschützten Bereich unterteilt; Platzieren einer Sonotrode auf dem Anschlussfuß und Ultraschallschweißen des Anschlussfußes an das Substrat; und Erzeugen eines Fluidstroms in einem Spalt zwischen der Schutzwandung und dem Substrat von dem geschützten Bereich in den ungeschützten Bereich, so dass beim Ultraschallschweißen entstehende Partikel davon abgehalten werden, von dem ungeschützten Bereich in den geschützten Bereich zu gelangen.

Zusammenfassend wird während des Ultraschallschweißens ein Fluidstrom durch den Spalt erzeugt, der (zusammen mit der Schutzwandung) verhindert, dass Partikel in die geschützten Bereiche eindringen können. Das Herstellungsverfahren für das Halbleitermodul ist auf diese Weise relativ günstig, da die Schutzwandung zusammen mit dem Rest des Gehäuses gleichzeitig hergestellt werden kann und nach dem Schweißen im Modul verbleiben kann. Während des Schweißens muss nur eine Quelle für den Fluidstrom bereitgestellt werden.

Gemäß einer Ausführungsform der Erfindung wird der Fluidstrom durch Einblasen von Fluid in den geschützten Bereich erzeugt, beispielsweise mit einem Gebläse über eine Einlassöffnung im Gehäuse, das einen höheren Druck im geschützten Bereich erzeugt, der sich über den Spalt in den ungeschützten Bereich ausgleicht.

### KURZE BESCHREIBUNG DER FIGUREN

Im Folgenden werden Ausführungsbeispiele der Erfindung mit Bezug auf die beiliegenden Figuren detailliert beschrieben.
Fig. 1 zeigt einen schematischen Querschnitt durch ein Halbleitermodul gemäß einer Ausführungsform der Erfindung.
Fig. 2 zeigt eine schematische Draufsicht auf ein Halbleitermodul gemäß einer Ausführungsform der Erfindung.
Fig. 3 zeigt den Querschnitt aus der Fig. 1 mit Fluidströmen, um ein Verfahren zum Herstellen eines Halbleitermoduls gemäß einer Ausführungsform der Erfindung zu beschreiben.

Die in den Figuren verwendeten Bezugszeichen und ihre Bedeutung sind in zusammenfassender Form in der Liste der Bezugszeichen aufgeführt. Grundsätzlich sind identische oder ähnliche Teile mit den gleichen Bezugszeichen versehen.

### DETAILLIERTE BESCHREIBUNG VON AUSFÜHRUNGSBEISPIELEN

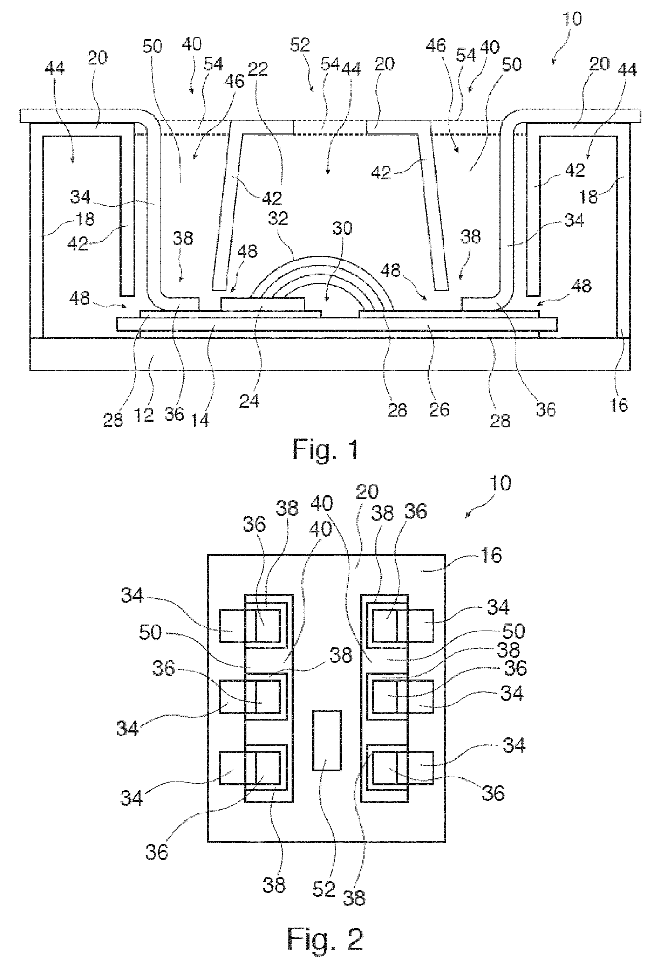

Fig. 1 zeigt ein Halbleitermodul 10 mit einer Basisplatte 12, einem Substrat 14 und einem Gehäuse 16, das seitlich an der Basisplatte 12 befestigt ist. Das Gehäuse 16 umfasst eine Seitenwandung 18, mit der es an der Basisplatte 12 befestigt ist und eine Deckplatte 20, die zusammen mit der Seitenwandung 18 und der Basisplatte 12 einen Innenraum 22 bildet, in dem das Substrat 14 und auf dem Substrat 14 befestigte Halbleiterchips 24 befestigt sind.

Das Substrat 14 weist einen Kern aus Keramik 26 auf, der auf beiden Seiten mit einer Metallisierung 28 beschichtet ist. Das Substrat 14 ist mit einer Metallisierung 28 mit der Basisplatte 12 verbunden. Die Metallisierung 28 auf der gegenüberliegenden Seite ist strukturiert, so dass Zonen 30 der Keramik 26 freiliegen. Auf dieser Seite sind die Chips 24 mit der Metallisierung 28 verbunden. Die Chips 24 können beispielsweise mit Bonddrähten 32 mit anderen Bereichen der Metallisierung 28 verbunden sein.

Das Halbleitermodul 10 umfasst weiter Anschlüsse 34, die jeweils mit einem Fuß 36 mit einer Anschlussstelle 38 auf der Metallisierung 28 verschweißt sind. Die Anschlüsse 34 ragen aus Öffnungen 40 in der Deckplatte 20 aus dem Gehäuse 16 und können beispielsweise aus einem abgewinkelten Kupferstreifen hergestellt sein.

Die Öffnungen 40 umgebend umfasst das Gehäuse Schutzwände 42, die von der Deckplatte 20 in den Innenraum 22 ragen und fast bis zu den Anschlussstellen 38 reichen. Die Schutzwände 42 teilen den Innenraum 22 bzw. die Oberfläche des Substrats 14 in geschützte Bereiche 44 und ungeschützte Bereiche 46 ein. Zwischen den Schutzwänden 42 und dem Substrat 14 befindet sich ein Spalt 48, der einen Fluidaustausch zwischen den geschützten Bereichen 44 und ungeschützten Bereichen 46 ermöglicht.

Jede Schutzwandung 42 bildet einen Kanal 50 im Innenraum 22, der lediglich über den Spalt 48 mit dem Rest des Innenraums 22 verbunden ist. Die ungeschützten Bereiche 46 werden im Wesentlichen aus den Kanälen 50 gebildet. Der geschützte Bereich 44 umschließt den Rest des Innenraums 22 und nimmt die Chips 24, die Bondrähte 32 und die freiliegenden Zonen 30 des Substrats 14 auf.

Die Öffnungen 40 werden während der Herstellung des Halbleitermoduls 10 als Auslassöffnung 40 verwendet, aus denen beim Ultraschallschweißen entstehende Partikel ausgeblasen werden.

Zum Einblasen des Fluids weist das Gehäuse 16 in der Deckplatte 20 eine Einlassöffnung 52 auf, die in einen geschützten Bereich 44 mündet. Nachdem die Anschlüsse 34 mit dem Substrat 14 verschweißt wurden, können die Öffnungen 40 und/oder 52 mit Einsätzen bzw. Verschlüssen 54 verschlossen werden.

Die Fig. 2 zeigt ein Halbleitermodul 10 (beispielsweise das Modul aus der Fig. 1) von oben. Es ist zu erkennen, dass die Öffnungen 40 und die Kanäle 50 einen länglichen Querschnitt aufweisen können, um mehrere Anschlüsse 34 aufzunehmen.

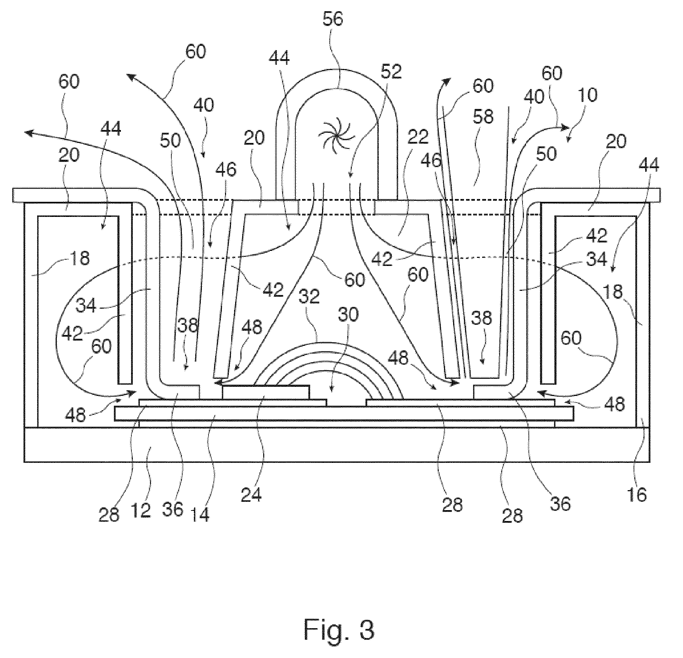

Die Fig. 3 zeigt das Halbleitermodul 10 während des Schweißens und illustriert diesen Abschnitt des Herstellungsverfahrens. Über der Einlassöffnung 52 befindet sich ein Gebläse 56. In eine der Öffnungen 40 und den zugehörigen Kanal 50 ist eine Sonotrode 58 auf dem Fuß 36 des Anschlusses 34 abgesetzt.

In einem ersten Verfahrensschritt wird das Halbleitermodul ohne die Anschlüsse 34 mit der Basisplatte 12, dem Substrat 14 auf der Basisplatte 12 und dem Gehäuse 16, das bereits an der Basisplatte 12 befestigt ist, bereitgestellt.

Danach werden die Anschlüsse 34 durch die Öffnungen 40 in die Kanäle 50 gesteckt, so dass der Anschlussfuß 36 auf der jeweiligen Anschlussstelle 38 des Substrats 14 platziert wird.

Auf den Anschlussfuß wird eine Sonotrode 58 platziert und der Anschlussfuß 36 wird an das Substrat 14 bzw. die jeweilige Anschlussstelle 38 geschweißt.

Beim Ultraschallschweißen entstehen Kupfer-Partikel von bis zu 1 mm Größe. Diese werden etwa mit einer Geschwindigkeit von 10 m/s weggeschleudert.

Gleichzeitig wird mittels des Gebläses 56 ein Fluidstrom 60 erzeugt, in dem durch die Öffnung 52 Fluid in den geschützten Bereich 44 geblasen wird. Durch den entstehenden Überdruck erfolgt ein Druckausgleich durch den Spalt 48 von dem geschützten Bereich 44 in den ungeschützten Bereich 46, so dass beim Ultraschallschweißen entstehende Partikel davon abgehalten werden, von dem ungeschützten Bereich 46 in den geschützten Bereich 44 zu gelangen.

Versuche und theoretische Überlegungen haben ergeben, dass, um Partikel mit einem Luftstrom innerhalb weniger mm abzubremsen, ein Luftstrom von bis zu dem 30-fachen der Partikelgeschwindigkeit notwendig sein kann. Eine entsprechende Luftgeschwindigkeit kann lokal um die Anschlussstellen 38 durch eine Einengung des Luftstroms mit dem Spalt 48 erreicht werden. Damit die Partikel aus dem Halbleitermodul 10 gegen die Schwerkraft heraus befördert werden können, kann eine Luftgeschwindigkeit von ca. 15 m/s erforderlich sein.

Zwischen den geschützten und den ungeschützten Bereichen fließt der Fluidstrom 60 mit hoher Geschwindigkeit durch den Spalt 48. Partikel, die während des Schweißprozesses entstehen, können die geschützten Bereiche 44 nicht durch den Spalt gegen den Fluidstrom 60 erreichen. Weiter werden die Partikel mit dem Fluidstrom 60 durch die Auslassöffnungen 40 nach außen geblasen.

Die Öffnungen 40, 52 können am Ende mit einer Abdeckung bzw. einem Einsatz 54 verschlossen werden.

Ergänzend ist darauf hinzuweisen, dass "umfassend" keine anderen Elemente oder Schritte ausschließt und "eine" oder "ein" keine Vielzahl ausschließt. Ferner sei darauf hingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkung anzusehen.

### LISTE DER BEZUGSZEICHEN

- 10: Halbleitermodul
- 12: Basisplatte
- 14: Substrat
- 16: Gehäuse
- 18: Seitenwandung
- 20: Deckplatte
- 22: Innenraum
- 24: Halbleiterchip
- 26: Keramik
- 28: Metallisierung
- 30: freiliegende Zone
- 32: Bonddraht
- 34: Anschluss
- 36: Anschlussfuß
- 38: Anschlussstelle
- 40: Auslassöffnung
- 42: Schutzwandung
- 44: geschützter Bereich
- 46: ungeschützter Bereich
- 48: Spalt
- 50: Kanal
- 52: Einlassöffnung
- 54: Einsatz
- 56: Gebläse
- 58: Sonotrode
- 60: Fluidstrom

## Patentansprüche

1. Halbleitermodul (10), umfassend:
eine Basisplatte (12);
ein Substrat (14) auf der Basisplatte (12), das eine Metallisierung (28) auf wenigstens einer Seite aufweist und das wenigstens einen Halbleiterchip (24) trägt;
ein Gehäuse (16), das an der Basisplatte (12) befestigt ist und das Substrat (14) wenigstens teilweise umschließt;
wenigstens einen Anschluss (34), der an einem anderen Ende einen Anschlussfuß (36) aufweist, der mittels Ultraschallschweißen auf einer Anschlussstelle (38) der Metallisierung (28) befestigt ist;
wobei das Gehäuse (16) eine Schutzwandung (42) aufweist, die den Anschluss (34) umgibt und einen Innenraum (22) des Gehäuses (16) in einen ungeschützten Bereich (46) und einen geschützten Bereich (44) unterteilt;
wobei die Schutzwandung (42) derart ausgebildet ist, dass zwischen dem Substrat (14) und der Schutzwandung (42) ein Spalt (48) gebildet ist, der dazu ausgeführt ist, einen Fluidstrom (60) derart zu führen, dass beim Ultraschallschweißen des Anschlussfußes (36) auf die Anschlussstelle (38) entstehende Partikel davon abgehalten werden, von dem ungeschützten Bereich (46) in den geschützten Bereich (44) zu dringen.

2. Halbleitermodul (10) nach Anspruch 1,
wobei das Gehäuse (16) eine Einlassöffnung (52) aufweist, die in den geschützten Bereich (44) mündet, durch die ein Fluid in den geschützten Bereich (44) einblasbar ist.

3. Halbleitermodul (10) nach Anspruch 2,
wobei die Einlassöffnung (52) von einem Gehäuseeinsatz (54) verschlossen ist.

4. Halbleitermodul (10) nach einem der vorhergehenden Ansprüche,
wobei das Gehäuse (16) eine Auslassöffnung (40) aufweist, die über einen durch die Schutzwandung (42) gebildeten Kanal (50) in den ungeschützten Bereich (46) und/oder zum Anschlussfuß (36) führt.

5. Halbleitermodul (10) nach Anspruch 4,
wobei die Auslassöffnung (40) von einem Gehäuseeinsatz (54) verschlossen ist.

6. Halbleitermodul (10) nach Anspruch 4 oder 5,
wobei der Anschluss (34) aus der Auslassöffnung (40) herausragt.

7. Halbleitermodul (10) nach einem der vorhergehenden Ansprüche,
wobei das Gehäuse (16) den geschützten Bereich (44) bis auf eine Einlassöffnung (52) vollständig umschließt.

8. Halbleitermodul (10) nach einem der vorhergehenden Ansprüche,
wobei das Gehäuse (16) eine Deckplatte (20) aufweist, die über eine Seitenwandung (18) des Gehäuses (16) an der Basisplatte (12) befestigt ist;
wobei die Schutzwandung (42) mit der Deckplatte (20) verbunden ist und in den Innenraum (22) des Gehäuses (16) hineinragt.

9. Halbleitermodul (10) nach Anspruch 8,
wobei eine Auslassöffnung (40) und/oder eine Einlassöffnung (52) in der Deckplatte (20) vorgesehen sind.

10. Halbleitermodul (10) nach einem der vorhergehenden Ansprüche,
wobei Halbleiterchips (24) und/oder freiliegende Zonen (30) des Substrats (16) ohne Metallisierung (28) im geschützten Bereich (44) angeordnet sind.

11. Halbleitermodul (10) nach einem der vorhergehenden Ansprüche,
wobei der Spalt (48) 0,2 bis 4 mal eine Dicke des Anschlussfußes (36) aufweist; oder wobei der Spalt (48) 0,4 bis 2 mal eine Dicke des Anschlussfußes (36) aufweist.

12. Halbleitermodul (10) nach einem der vorhergehenden Ansprüche,
wobei mehr als ein Anschluss (34) von der Schutzwandung (42) umgeben sind.

13. Halbleitermodul (10) nach einem der vorhergehenden Ansprüche,
wobei der Anschluss (34) an dem Ende, das aus dem Gehäuse (16) herausragt, abgewinkelt ist und das Gehäuse (16) umgreift.

14. Verfahren zum Herstellen eines Halbleitermoduls (10) nach einem der vorhergehenden Ansprüche, das Verfahren umfassend:
Bereitstellen eines Halbleitermoduls (10) mit einer Basisplatte (12), einem Substrat (14) auf der Basisplatte (12), und einem Gehäuse (16), das an der Basisplatte (12) befestigt ist;
Platzieren eines Anschlussfußes (36) eines Anschlusses (34) auf einer Anschlussstelle (38) des Substrats (14), die von einer Schutzwandung (42) des Gehäuses (16) umgeben ist, wobei die Schutzwandung (42) einen Innenraum (22) des Gehäuses (16) in einen ungeschützten Bereich (46) und einen geschützten Bereich (44) unterteilt;
Platzieren einer Sonotrode (58) auf dem Anschlussfuß (36) und Ultraschallschweißen des Anschlussfußes (36) an das Substrat (14);
Erzeugen eines Fluidstroms (60) in einem Spalt (48) zwischen der Schutzwandung (42) und dem Substrat (14) von dem geschützten Bereich (44) in den ungeschützten Bereich (46), so dass beim Ultraschallschweißen entstehende Partikel davon abgehalten werden, von dem ungeschützten Bereich (46) in den geschützten Bereich (44) zu gelangen.

15. Verfahren nach Anspruch 14,
wobei der Fluidstrom (60) durch Einblasen von Fluid in den geschützten Bereich (44) erzeugt wird.

## Claims

1. Semiconductor module (10), comprising:
a base plate (12);
a substrate (14) on the base plate (12), which has a metallization (28) on at least one side and which carries at least one semiconductor chip (24);
a housing (16), which is attached to the base plate (12) and which at least partially encloses the substrate (14);
at least one terminal (34), which has at another end a terminal foot (36), which is attached on a terminal pad (38) of the metallization (28) by means of ultrasonic welding;
the housing (16) having a protective wall (42),
which encloses the terminal (34) and divides an interior space (22) of the housing (16) into an unprotected region (46) and a protected region (44) ;
the protective wall (42) being formed in such a way that between the substrate (14) and the protective wall (42) there is formed a gap (48), which is designed to carry a fluid flow (60) in such a way that particles produced during the ultrasonic welding of the terminal foot (36) to the terminal pad (38) are prevented from penetrating into the protected region (44) from the unprotected region (46).

2. Semiconductor module (10) according to Claim 1,
the housing (16) having an inlet opening (52), which opens out into the protected region (44) and through which a fluid can be blown into the protected region (44).

3. Semiconductor module (10) according to Claim 2,
the inlet opening (52) being closed by a housing insert (54).

4. Semiconductor module (10) according to one of the preceding claims,
the housing (16) having an outlet opening (40), which leads into the unprotected region (46) and/or to the terminal foot (36) by way of a channel (50) formed by the protective wall (42).

5. Semiconductor module (10) according to Claim 4,
the outlet opening (40) being closed by a housing insert (54).

6. Semiconductor module (10) according to Claim 4 or 5,
the terminal (34) protruding from the outlet opening (40).

7. Semiconductor module (10) according to one of the preceding claims,
the housing (16) enclosing the protected region (44) completely apart from an inlet opening (52).

8. Semiconductor module (10) according to one of the preceding claims,
the housing (16) having a cover plate (20) which is fastened to the base plate (12) by way of a side wall (18) of the housing (16);
the protective wall (42) being connected to the cover plate (20) and protruding into the interior space (22) of the housing (16).

9. Semiconductor module (10) according to Claim 8,
an outlet opening (40) and/or an inlet opening (52) being provided in the cover plate (20).

10. Semiconductor module (10) according to one of the preceding claims,
semiconductor chips (24) and/or exposed zones (30) of the substrate (16) without metallization (28) being arranged in the protected region (44).

11. Semiconductor module (10) according to one of the preceding claims,
the gap (48) having a thickness of 0.2 to 4 times that of the terminal foot (36); or
the gap (48) having a thickness of 0.4 to 2 times that of the terminal foot (36).

12. Semiconductor module (10) according to one of the preceding claims,
more than one terminal (34) being surrounded by the protective wall (42).

13. Semiconductor module (10) according to one of the preceding claims,
the terminal (34) being angled away at the end that protrudes from the housing (16) and reaching around the housing (16).

14. Process for producing a semiconductor module (10) according to one of the preceding claims, the process comprising:
providing a semiconductor module (10) having a base plate (12), a substrate (14) on the base plate (12), and a housing (16), which is attached to the base plate (12);
placing a terminal foot (36) of a terminal (34) on a terminal pad (38) of the substrate (14) that is surrounded by a protective wall (42) of the housing (16), the protective wall (42) dividing an interior space (22) of the housing (16) into an unprotected region (46) and a protected region (44);
placing a sonotrode (58) on the terminal foot (36) and ultrasonically welding the terminal foot (36) to the substrate (14);
producing a fluid flow (60) in a gap (48) between the protective wall (42) and the substrate (14) from the protected region (44) into the unprotected region (46), so that particles produced during the ultrasonic welding are prevented from passing from the unprotected region (46) into the protected region (44).

15. Process according to Claim 14,
the fluid flow (60) being produced by blowing fluid into the protected region (44).

## Revendications

1. Module semi-conducteur (10), comprenant:
- une plaque de base (12);
- un substrat (14) sur la plaque de base (12), qui présente une métallisation (28) sur au moins un côté et qui porte au moins une puce à semi-conducteur (24) ;
- un boîtier (16), qui est fixé à la plaque de base (12) et qui entoure au moins partiellement le substrat (14);
- au moins un raccord (34), qui présente à une autre extrémité un pied de raccord (36), qui est fixé par soudage aux ultrasons à un point de raccordement (38) de la métallisation (28);
dans lequel le boîtier (26) présente une paroi de protection (42), qui entoure le raccord (34) et divise un espace intérieur (22) du boîtier (16) en une zone non protégée (46) et une zone protégée (44);
dans lequel la paroi de protection (42) est configurée de telle manière qu'il se forme entre le substrat (14) et la paroi de protection (42) une fente (48), qui est réalisée en vue de guider un courant de fluide (60) de telle manière que des particules produites lors du soudage aux ultrasons du pied de raccord (36) sur le point de raccordement (38) soient empêchées de passer de la zone non protégée (46) dans la zone protégée (44).

2. Module semi-conducteur (10) selon la revendication 1, dans lequel le boîtier (16) présente une ouverture d'entrée (52), qui débouche dans la zone protégée (44), par laquelle un fluide peut être insufflé dans la zone protégée (44).

3. Module semi-conducteur (10) selon la revendication 2, dans lequel l'ouverture d'entrée (52) est fermée par un insert de boîtier (54).

4. Module semi-conducteur (10) selon l'une quelconque des revendications précédentes, dans lequel le boîtier (16) présente une ouverture de sortie (40), qui conduit dans la zone non protégée (46) et/ou au pied de raccord (36) par un canal (50) formé à travers la paroi de protection (42).

5. Module semi-conducteur (10) selon la revendication 4, dans lequel l'ouverture de sortie (40) est fermée par un insert de boîtier (54).

6. Module semi-conducteur (10) selon la revendication 4 ou 5, dans lequel le raccord (34) sort par l'ouverture de sortie (40).

7. Module semi-conducteur (10) selon l'une quelconque des revendications précédentes, dans lequel le boîtier (16) entoure entièrement la zone protégée (44) jusque sur une ouverture d'entrée (52).

8. Module semi-conducteur (10) selon l'une quelconque des revendications précédentes, dans lequel le boîtier (16) présente une plaque de couverture (20), qui est fixée à la plaque de base (12) par une paroi latérale (18) du boîtier (16);
dans lequel la paroi de protection (42) est assemblée à la plaque de couverture (20) et pénètre dans l'espace intérieur (22) du boîtier (16).

9. Module semi-conducteur (10) selon la revendication 8, dans lequel il est prévu une ouverture de sortie (40) et/ou une ouverture d'entrée (52) dans la plaque de couverture (20).

10. Module semi-conducteur (10) selon l'une quelconque des revendications précédentes, dans lequel des puces à semi-conducteur (24) et/ou des zones libres (30) du substrat (16) sont disposées sans métallisation (28) dans la zone protégée (44).

11. Module semi-conducteur (10) selon l'une quelconque des revendications précédentes, dans lequel la fente (48) présente une largeur de 0,2 à 4 fois une épaisseur du pied de raccord (36); ou dans lequel la fente (48) présente une largeur de 0,4 à 2 fois une épaisseur du pied de raccord (36).

12. Module semi-conducteur (10) selon l'une quelconque des revendications précédentes, dans lequel plus qu'un raccord (34) sont entourés par la paroi de protection (42).

13. Module semi-conducteur (10) selon l'une quelconque des revendications précédentes, dans lequel le raccord (34) est coudé à l'extrémité qui sort hors du boîtier (16), et encercle le boîtier (16).

14. Procédé de fabrication d'un module semi-conducteur (10) selon l'une quelconque des revendications précédentes, le procédé comprenant les étapes suivantes:
- préparer un module semi-conducteur (10) avec une plaque de base (12), un substrat (14) sur la plaque de base (12), et un boîtier (16), qui est fixé à la plaque de base (12);
- placer un pied de raccord (36) d'un raccord (34) sur un point de raccordement (38) du substrat (14), qui est entouré par une paroi de protection (42) du boîtier (16), dans lequel la paroi de protection (42) divise un espace intérieur (22) du boîtier (16) en une zone non protégée (46) et une zone protégée (44);
- place une sonotrode (58) sur le pied de raccord (36) et souder aux ultrasons le pied de raccord (36) au substrat (14);
- produire un courant de fluide (60) dans une fente (48) entre la paroi de protection (42) et le substrat (14), de la zone protégée (44) à la zone non protégée (46), de telle manière que des particules produites lors du soudage aux ultrasons soient empêchées de passer de la zone non protégée (46) dans la zone protégée (44).

15. Procédé selon la revendication 14, dans lequel le courant de fluide (60) est produit par insufflation de fluide dans la zone protégée (44).
